# EUROPEAN PATENT APPLICATION

(11) **EP 4 727 284 A1**
(43) Date of publication of application: **15.04.2026**
(21) Application number: 25208338.1
(22) Date of filing: 13.10.2025
(51) Int. Cl.: H10D 18/00, H10D 18/01, H10D 62/10, H10D 62/17

(54) **A METHOD OF MAKING ISOLATION STRUCTURE THYRISTOR**

(30) Priority: 14.10.2024 CN 202411436086
(71) Applicant: Littelfuse Semiconductor (Wuxi) Co., Ltd., Wuxi, Jiangsu 214142 (CN)
(72) Inventor: Zhou, Jifeng, Wuxi, 214142 (CN); Gu, Xingchong, Wuxi, 214142 (CN); He, Lei, Wuxi, 214142 (CN)
(74) Representative: Arnold & Siedsma

(57) **Abstract**

A thyristor semiconductor includes a first layer, located on a first surface of a substrate, where the first layer is a first P layer. A second layer, located on a second surface of the substrate, is a second P layer. The second surface is opposite the first surface. A third layer is located between the first layer and the substrate. An isolation region is located along an edge of the substrate The isolation region is adjacent the second P layer. An emitter, next to the third layer, is connected to a cathode.

## Description

### Field of the Disclosure

Embodiments of the present disclosure relate to thyristors and, more particularly, semiconductor-based thyristors.

### Background

Thyristors are semiconductor switches used to control the flow of electrical current. Thyristors are used in applications such as home appliances (lighting, heating, temperature control, alarm activation, fan speed), electrical tools (for controlling motor speed, stapling event, battery charging), and outdoor equipment (water sprinklers, gas engine ignition, electronic displays, area lighting, sports equipment, physical fitness). In many applications, thyristors perform key functions and assist in meeting environmental, speed, and reliability specifications which their electromechanical counterparts cannot fulfill.

Like diodes, thyristors are three-terminal devices with a PNPN configuration consisting of an anode terminal connected to a first P section, a cathode terminal connected to a second N section, and a gate terminal connected to the P section nearest the cathode. Thyristors are known to have three P-N junctions. When a positive voltage is applied at the gate terminal of the device, the thyristor turns on and will remain on, even if the gate terminal signal is removed. If current flowing through the thyristor drops below a latch-on current level, the thyristor will turn off.

Non-repetitive peak off-state voltage, known also as VDSM, is an important thyristor characteristic. VDSM applies when there is no signal between the gate and cathode, and within the rated junction temperature range. VDSM is applicable for time widths that are less than half of a sine wave at commercial frequency. Repetitive peak reverse current of a silicon-controlled rectifier (SCR), known also as IRRM, is another important thyristor characteristic. IRRM is the maximum instantaneous value of the reverse current resulting from the application of repetitive peak reverse voltage. VDSM and IRRM are affected by the arrangement of the materials forming the three P-N junctions.

It is with respect to these and other considerations that the present improvements may be useful.

### Summary

This Summary is provided to introduce a selection of concepts in a simplified form that are further described below in the Detailed Description. This Summary is not intended to identify key or essential features of the claimed subject matter, nor is it intended as an aid in determining the scope of the claimed subject matter.

A thyristor semiconductor in accordance with the present disclosure may include a first layer, located on a first surface of a substrate, where the first layer is a first P layer. A second layer, located on a second surface of the substrate, is a second P layer. The second surface is opposite the first surface. A third layer is located between the first layer and the substrate. An isolation region is located along an edge of the substrate. The isolation region is connected to the second P layer. An emitter, next to the third layer, is connected to a cathode.

A method of forming a thyristor semiconductor in accordance with the present disclosure may include providing an N- substrate, forming a first layer in a first region above the N substrate and simultaneously in a second region below the N- substrate, for example by performing P type isolation photo resist and diffusion and performing P- base gallium diffusion simultaneously on the first region and the second region. The method may further include performing a grinding operation to the second region to remove P- from the second region.

The method may include providing an N- substrate, forming a first layer in a first region above the N substrate and simultaneously in a second region below the N- substrate for example by performing P type isolation photo resist and diffusion, performing P- base boron diffusion in the first region, and performing P base diffusion in the first region and the second region.

The disclosure also relates to the use of the thyristor semiconductor for controlling the flow of electric current.

The disclosure also related to an electrical circuit comprising the thyristor semiconductor.

### Brief Description of the Drawings

**FIGs. 1A-1B** are diagrams illustrating a thyristor semiconductor, in accordance with the prior art;
**FIGs. 2A-2B** are diagrams illustrating a thyristor semiconductor, in accordance with the present disclosure;
**FIG. 3** is a flow diagram illustrating a manufacturing method for the thyristor semiconductor of **FIGs. 1A-1B,** in accordance with the prior art;
**FIG. 4** is a flow diagram illustrating a first manufacturing method for the thyristor semiconductor of **FIGs. 2A-2B****,** in accordance with the present disclosure ; and
**FIG. 5** is a flow diagram illustrating second manufacturing method for the thyristor semiconductor of **FIGs. 2A-2B****,** in accordance with the present disclosure.

### Detailed Description

A thyristor semiconductor and method of manufacturing the thyristor semiconductor are disclosed. The semiconductor thyristor features a double base at the cathode side to improve VDSM and features a single base at the anode side to reserve enough substrate width, thus reducing IRRM.

For the sake of convenience and clarity, terms such as "top", "bottom", "upper", "lower", "vertical", "horizontal", "lateral", "transverse", "radial", "inner", "outer", "left", and "right" may be used herein to describe the relative placement and orientation of the features and components, each with respect to the geometry and orientation of other features and components appearing in the perspective, exploded perspective, and cross-sectional views provided herein. Said terminology is not intended to be limiting and includes the words specifically mentioned, derivatives therein, and words of similar import.

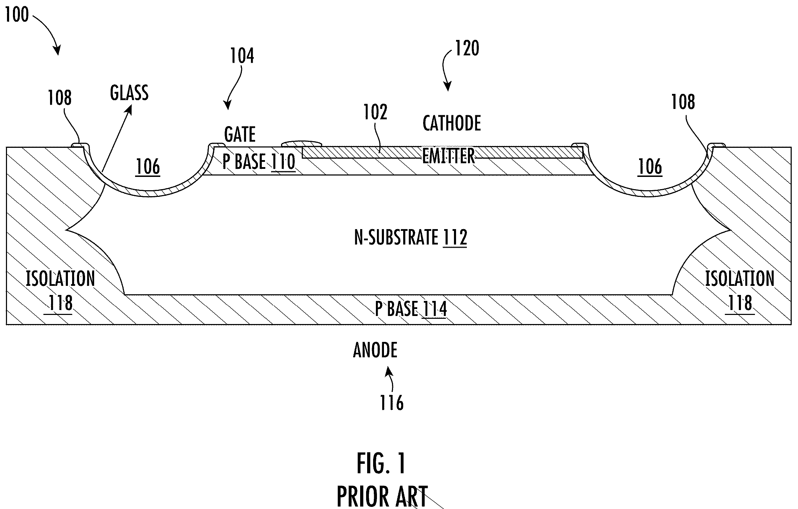

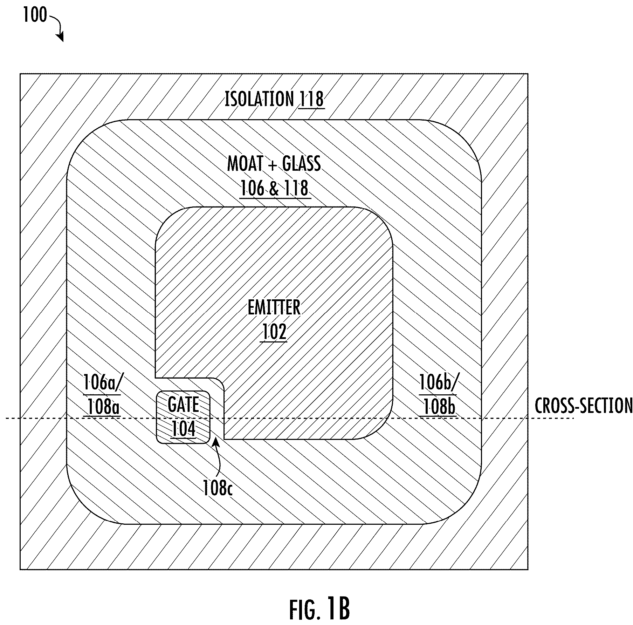

**FIGs. 1A-1B** are representative drawings of a thyristor semiconductor 100, according to the prior art. **FIG. 1A** is a cross-sectional view of the thyristor semiconductor 100 while **FIG. 1B** is a top view of the thyristor semiconductor 100. The thyristor semiconductor 100 is known as a single-sided mesa type of thyristor. The thyristor semiconductor 100 includes a gate 104, a cathode 120, and an anode 116, as shown. A moat 106, shown in two portions 106a and 106b in **FIG. 1A,** is disposed to surround an emitter 102 of the thyristor semiconductor 100, as shown in FIG. 1B, with the moat portion 106a being adjacent the gate 104 and the moat 106b being adjacent the emitter 102. In addition to the emitter 102, the semiconductor region features a P base 110, an N- substrate 112, and a P base 114, with an isolation region 118 being disposed along an outer edge and surrounding the moat 106 of the thyristor semiconductor 100. The emitter 102 is an N+ doped area (heavy doping). Thus, for the thyristor semiconductor 100, there is a PN junction between the emitter 102 and the P base 110, a second PN junction between the P base 110 and the N- substrate 112, and a third PN junction between the N- substrate 112 and the P base 114, for a total of three PN junctions, as is characteristic of thyristors.

The semiconductor silicon is etched to form the moat 106 and then glass is used as the passivation region. Glass 108 covers the entire moat 106, visible as glass portions 108a, 108b, and 108c, with the glass portion 108c being disposed between the gate 104 and the emitter 102, with the glass portion 108c also being disposed both on the emitter 102 and the P base 110.The P base 110 and the P base 114 are formed at the same time and have the same doping characteristics. This is known as a symmetrical P- base diffusion structure at the anode 116 and cathode 120 sides (in other words, on either side of the N- substrate 112). By doing the P base 110 and P base 114 deposition and diffusion at the same time, the thyristor semiconductor 100 has the same junction depth for both the anode 116 and the cathode 120.

To increase the breakdown voltage of a thyristor semiconductor over that of the thyristor semiconductor 100, the P- base junction depths may be increased. For example, a light P- base diffusion area may be introduced to increase the breakdown voltage. The process is symmetrical, the light P- base diffusion is done at the cathode and at the anode. If a P-base is added only at the cathode 120, the P base 110 is deeper than the P base 114. But if P-base is added at both the cathode 120 and anode 116 sides, both P base 110 and P base 114 are deeper than before. This causes the N- substrate to be reduced in thickness because both P base 110 and P base 114 are deeper than they were before.

A thinner N- substrate will reduce the drift region area of the N- substrate. The result is that a limit is imposed on the reverse breakdown capability of the thyristor semiconductor because the N substrate is thinner. To achieve a high breakdown voltage, a thicker wafer may be used. But a thicker wafer will result in a higher VT (on-state voltage). VT is the principal voltage when the thyristor is in the on state.

Further, by increasing the P base junction depth of the thyristor semiconductor 100, the VDSM capability can be improved. However, that results in a thinner N- substrate, which increases the IRRM. It is difficult to design a thyristor semiconductor that optimizes both VDSM and IRRM.

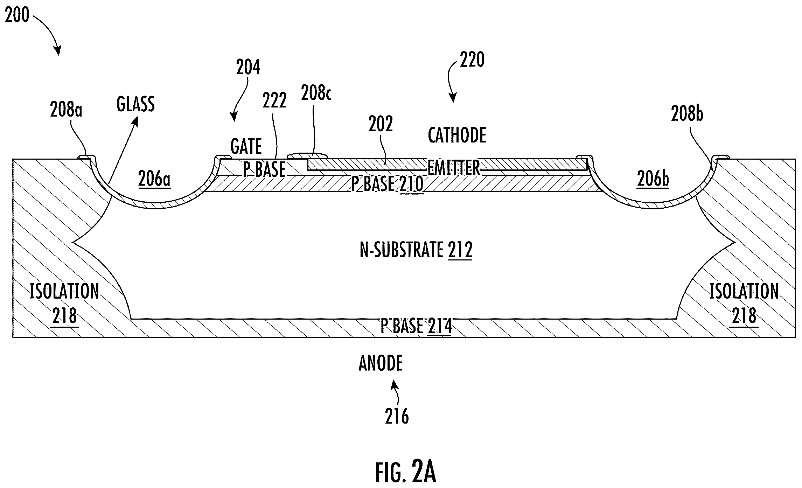

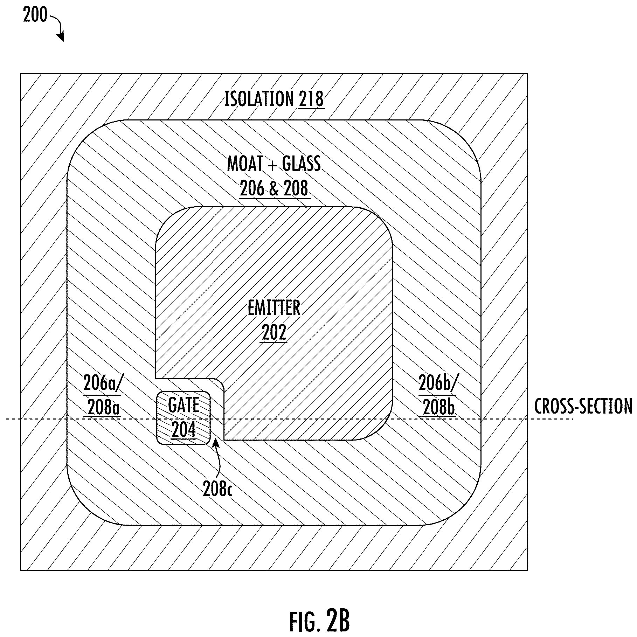

**FIGs. 2A** and **2B** are representative drawing of a thyristor semiconductor 200, according to exemplary embodiments. **FIG. 2A** is a cross-sectional view of the thyristor semiconductor 200 while **FIG. 2B** is a top view of the thyristor semiconductor 200. The structure of the thyristor semiconductor 200 solves the problem described above. The thyristor semiconductor 200 includes a gate 204, a cathode 220, and an anode 216, as shown. A moat 206, shown in two portions 206a and 206b in **FIG. 2A****,** is disposed to surround an emitter 202 of the thyristor semiconductor 200, as shown in **FIG. 2B****,** with the moat portion 206a being adjacent the gate 204 and the moat 206b being adjacent the emitter 202.

In addition to the emitter 202, the semiconductor region also features a P base 222 (at the gate 204), a P base 210, an N- substrate 212, and a P base 214, with an isolation regions 218 disposed on opposite sides of the thyristor semiconductor 200, with an isolation region 218 being disposed along an outer edge and surrounding the moat 206 of the thyristor semiconductor 200. The emitter 202 is an N+ doped area (heavy doping). Thus, for the thyristor semiconductor 200, there is a PN junction between the emitter 202 and the P base 222, a second PN junction between the P base 210 and the N- substrate 212, and a third PN junction between the N- substrate 212 and the P base 214, for a total of three PN junctions, as is characteristic of thyristors.

The semiconductor silicon is etched to form the moat 206 and then glass is used as the passivation region. Glass 208 covers the entire moat 206, visible as glass portions 208a, 208b, and 208c, with the glass portion 208c being disposed between the gate 204 and the emitter 202, with the glass 208c also being disposed both on the emitter 202 and the P base 222.

The P base 222 and the P base 214 are diffused at the same time and have the same doping characteristics. Nevertheless, whereas the thyristor semiconductor 100 is symmetric, the structure of the thyristor semiconductor 200 is asymmetric, due to the addition of a P- base 210 in the cathode region. The thyristor semiconductor 200 features both a P- base 210 and a P base 222 in the cathode 220 region. In some embodiments, this increases the blocking capacity of the thyristor semiconductor 200, thus improving the VDSM characteristic. On the back (anode 216) side, a single P base diffusion is used (P base 214). This enables the thickness of the N- substrate 212 to be maintained, so that it is not too thin and the use of a thicker wafer can be avoided. In some embodiments, the voltage capability of the thyristor semiconductor 200 is superior to that of the thyristor semiconductor 100, due to the change in structure. In some embodiments, the N-substrate 212 of the thyristor semiconductor 200 is a little thicker than the N- substrate 112 of the thyristor semiconductor 100 (notice the P- base 114 **(****FIG. 1****)** is a little thicker than the P- base 214 **(****FIG. 2****).** Also, in some embodiments, the P- base 210 is doped differently than the P- base 110 is. In exemplary embodiments, the doping of the P- base 210 is thinner (more lightly doped) than the doping of the P base 222. In some embodiments the P- base 210 doping concentration is 2.5E16/cm³ while the P base 222 doping is 1.5E18/cm³.

In some embodiments, the thyristor semiconductor 200 is characterized as having a double base at the cathode 220, both a P base 222 and a P- base 210. Further, in some embodiments, the thyristor semiconductor 200 is characterized as having a single base (P base 214) at the anode 216. The single base at the anode 216 reserves enough N- substrate width 212 to reduce IRRM. The structure of the thyristor semiconductor 200 thus improves both VDSM and IRRM, in some embodiments.

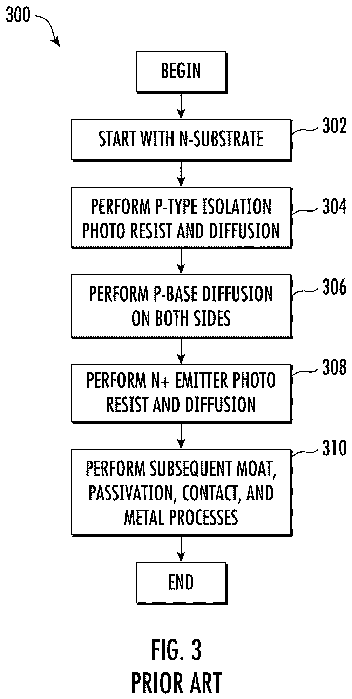

**FIG. 3** is a representative flow diagram showing a method 300 performed in producing the thyristor semiconductor 100 of **FIG. 1**, according to the prior art. An N- substrate is obtained (block 302). A P type isolation photo resist and diffusion are performed, with this operation happening simultaneously on both sides of the N- substrate (block 304). P base diffusion is then performed on both sides of the N- substrate (block 306). The P base may be boron doping or gallium doping. An N+ photo resist and diffusion are then performed at the emitter (block 308). Subsequent moat, passivation, contact, and metal processes are then performed (block 310).

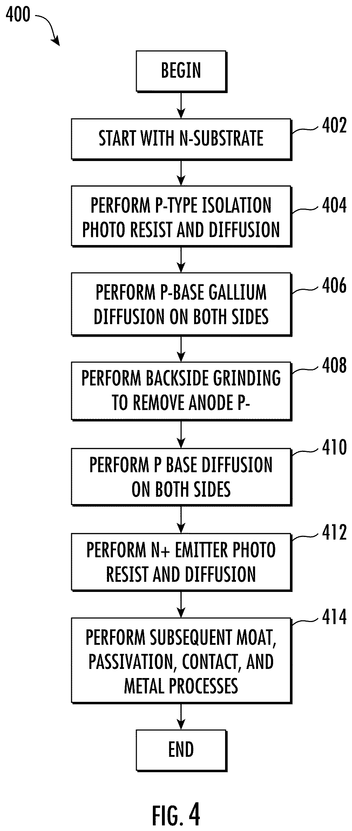

**FIG. 4** is a representative flow diagram showing a method 400 performed in producing the thyristor semiconductor 200 of **FIG. 2****,** according to some embodiments. As with the method 300, the process starts with obtaining an N- substrate (block 402). P type isolation photo resist and diffusion operations are performed, with this operation happening simultaneously on both sides (e.g., the cathode side and the anode side) of the N- substrate (block 404). To form the P-base layer 210, P- base gallium diffusion is then performed on both sides (the cathode side and the anode side) of the N- substrate (block 406).

Next, a grinding operation is performed on the backside (e.g., anode side) to remove anode P- (block 408). P base diffusion is performed on both sides of the N- substrate (the cathode side and the anode side) (block 410), such that the P base 222 and P base 214 are formed. In some embodiments, the P base is boron doped. In other embodiments, the P base is gallium doped. Thus, using the method 400, the P- base 210 is formed using gallium diffusion (block 406) but, since the gallium diffusion is done on both the anode and cathode sides, grinding is done at the anode side to remove P- (block 408) and subsequently, the P base 214 and P base 222 are formed by using P base diffusion (block 410).

To form the emitter 202 layer, N+ emitter photo resist and diffusion are performed at the emitter (e.g., emitter 202) (block 412). In some embodiments, the N+ emitter doping is heavily doped, as compared to the N- substrate doping. Subsequently, moat, passivation, contact, and metal processes are performed (block 414), thus forming the thyristor semiconductor 200.

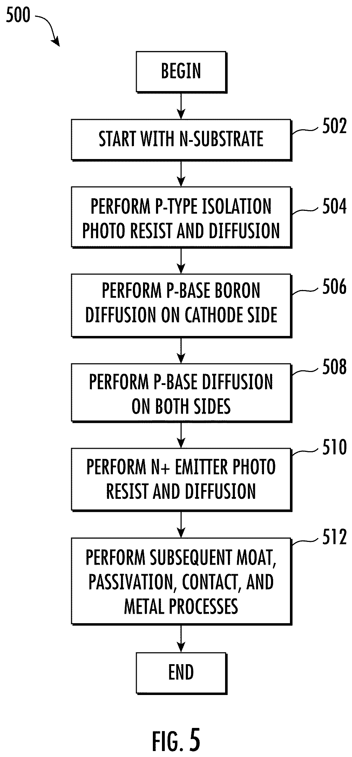

**FIG. 5** is a representative flow diagram showing an alternative method 500 performed in producing the thyristor semiconductor 200 of **FIG. 2****,** according to some embodiments. As with the methods 300 and 400, the process starts with a semiconductor wafer doped to be an N- substrate (block 502). P type isolation photo resist and diffusion operations are performed, with this operation happening simultaneously on both sides (the cathode side and the anode side) of the N-substrate (block 504). To form the P-base layer 210, P- base boron diffusion is then performed on the cathode side of the N- substrate (block 506), resulting in the P- base 210 **(****FIG. 2****).**

P base diffusion is performed on both sides of the N- substrate (simultaneously on the cathode side P base 222 and on the anode side P base 214) (block 508). In some embodiments, the P base is boron doped. In other embodiments, the P base is gallium doped. Thus, using the method 500, the P- base 210 is formed using boron diffusion (block 506) and, because the boron diffusion is only done on the cathode side, the grinding step (as in block 408) is unnecessary, and the P base 214 and P base 222 are formed thereafter (block 508).

To form the emitter 202 layer, N+ emitter photo resist and diffusion are performed at the emitter (e.g., emitter 202) (block 510). In some embodiments, the N+ emitter doping is heavily doped, as compared to the N- substrate doping. Subsequently, moat, passivation, contact, and metal processes are performed (block 512), thus forming the thyristor semiconductor 200.

As used herein, an element or step recited in the singular and proceeded with the word "a" or "an" should be understood as not excluding plural elements or steps, unless such exclusion is explicitly recited. Furthermore, references to "one embodiment" of the present disclosure are not intended to be interpreted as excluding the existence of additional embodiments that also incorporate the recited features.

While the present disclosure refers to certain embodiments, numerous modifications, alterations, and changes to the described embodiments are possible without departing from the sphere and scope of the present disclosure, as defined in the appended claim(s). Accordingly, it is intended that the present disclosure is not limited to the described embodiments, but that it has the full scope defined by the language of the following claims, and equivalents thereof.

## Claims

1. A thyristor semiconductor, comprising:
a first layer, disposed on a first surface of a substrate, comprising a first P layer;
a second layer, disposed on a second surface of the substrate, opposite the first surface, comprising a second P layer;
a third layer, disposed between the first layer and the substrate;
an isolation region, disposed along an edge of the substrate, wherein the isolation region is coupled to the second P layer; and
an emitter, disposed adjacent the first P layer, wherein the emitter is coupled to a cathode.

2. The thyristor semiconductor of claim 1, with one or more of the following:
- wherein the first P layer comprises a P base;
- wherein the second P layer comprises the P base;
- wherein the third layer comprises a P- base.

3. The thyristor semiconductor of claims 1 or 2, wherein the emitter is N+ doped.

4. The thyristor semiconductor of any of the preceding claims wherein the substrate is N-doped.

5. The thyristor semiconductor of any of the preceding claims, wherein the emitter and the first P layer form a first PN junction, the third P layer and the substrate form a second PN junction, and the substrate and the second P layer form a third PN junction.

6. The thyristor semiconductor of any of the preceding claims, further comprising a moat disposed adjacent the isolation region.

7. The thyristor semiconductor of claim 6, wherein the moat is adjacent the substrate, the first P layer, and the third P layer, and/or
wherein the moat is covered in glass, wherein the glass is used as a passivation region

8. A method of forming a thyristor semiconductor, comprising:
providing an N- substrate;
forming a first layer in a first region above the N- substrate and simultaneously in a second region below the N- substrate.

9. The method according to claim 8, further comprising performing P type isolation photo resist and diffusion.

10. The method according to claims 8 or 9, further comprising performing P- base gallium diffusion simultaneously on the first region and the second region.

11. The method according to claim 10, further comprising performing a grinding operation to the second region to remove P- from the second region.

12. The method of claim 8, further comprising performing P base diffusion on the first region and the second region.

13. The method of claim 8, 9 or 12, wherein the P base diffusion is boron doping or wherein the P base diffusion is gallium doping.

14. The method of any of the claims 8-13, wherein the P base diffusion is performed on the first region and/or the second region simultaneously.

15. The method of any of the preceding claims 8-14, further comprising performing N+ emitter photo resist and diffusion.
